# EUROPEAN PATENT APPLICATION

(11) **EP 4 219 371 A1**
(43) Date of publication of application: **02.08.2023**
(21) Application number: 20955361.9
(22) Date of filing: 29.09.2020
(51) Int. Cl.: B66B 1/52, H03K 17/94

(54) **CONTACTLESS ELEVATOR TOUCH DEVICE, AND METHOD FOR SETTING SAME**

(30) Priority: 22.09.2020 KR 20200121896
(71) Applicant: Smart Store Co., Ltd, Goyang-si, Gyeonggi-do 10442 (KR)
(72) Inventor: KIM, Yong-Chul, Goyang-si Gyeonggi-do 10388 (KR)
(74) Representative: De Vries & Metman
(86) International application number: PCT/KR2020/013351
(87) International publication number: WO 2022/065563

(57) **Abstract**

A non-contact elevator touch device according to the present invention comprises: a touch sensing unit installed around touch buttons of an elevator control panel and for sensing a touch according to an infrared signal traveling in a direction parallel to the elevator control panel at a position 1 to 10 cm apart from the elevator control panel in a perpendicular direction; and a controller providing touch coordinate information according to the signal of the touch sensing unit.

## Description

### FIELD OF THE INVENTION

The present invention relates to a non-contact elevator touch device and a setting method thereof, and in particular, to a non-contact elevator touch device capable of detecting a user's input motion in space even without physical contact, and to a setting method thereof applicable to an elevator in which a touch button is already installed.

### BACKGROUND OF THE INVENTION

In high-rise buildings such as buildings and apartments, elevators are installed to facilitate up and down movement. In general, a user who is riding an elevator can move to a specific floor or open or close the door of the elevator by pressing an elevator touch button indicating a floor number with his/her finger.

A conventional elevator touch button is a push method or a capacitance method that detects a change in capacitance, but in any case, a finger contact is inevitable.

Recently, sanitation of public facilities has been considered an important issue, and in particular, methods of minimizing hand contact with a lot of pollutants are being studied.

Therefore, in order to reduce the spread of infectious diseases by the elevator touch buttons installed in subway stations, airports, hospitals, etc., a structure that can be easily applied to existing elevators is needed.

### DETAILED DESCRIPTION OF THE INVENTION

### TECHNICAL CHALLENGE

The present invention provides a non-contact elevator touch device having a new configuration and a setting method thereof.

In addition, the present invention provides a non-contact elevator touch device and its setting method thereof that can detect a user's selected location even if the user does not touch the elevator touch button with a finger.

Furthermore, the present invention provides a method for setting a non-contact elevator touch device that can be additionally equipped with and used in an already installed elevator.

### TECHNICAL SOLUTIONS

A non-contact elevator touch device according to the present invention, comprises: a touch sensing unit installed around touch buttons of an elevator control panel and for sensing a touch according to an infrared signal traveling in a direction parallel to the elevator control panel at a position 1 to 10 cm apart from the elevator control panel in a perpendicular direction; and a controller providing touch coordinate information according to the signal of the touch sensing unit.

A method for setting a non-contact elevator touch device according to the present invention comprising: a touch sensing unit installed around touch buttons of an elevator control panel and for sensing a touch according to an infrared signal traveling in a direction parallel to the elevator control panel at a position 1 to 10 cm apart from the elevator control panel in a perpendicular direction; and a controller providing touch coordinate information according to the signal of the touch sensing unit, the method includes the steps of: (a) installing a non-contact elevator touch device around the touch buttons of the elevator control panel; (b) connecting a mobile terminal storing key panel data of elevator models to the non-contact elevator touch device; (c) displaying key panel data displayed on the mobile terminal and touch coordinate information detected by the non-contact elevator touch device at the same time on the mobile terminal; and (d) adjusting and setting the key panel data and the touch coordinate information detected by the non-contact elevator touch device.

### EFFECTS OF THE INVENTION

The present invention provides a non-contact elevator touch device having a new configuration and a setting method thereof.

In addition, the present invention provides a non-contact elevator touch device and its setting method thereof that can detect a user's selected location even if the user does not touch the elevator touch button with his/her finger.

Furthermore, the present invention provides a method for setting a non-contact elevator touch device that can be additionally equipped with and used in an already installed elevator.

### BRIEF DESCRIPTION OF THE DRAWINGS

FIG. 1 illustrates a non-contact elevator touch device and a control method thereof according to the present invention.
FIG. 2 is a view for explaining one embodiment of a method of detecting an x-axis coordinate and a y-axis coordinate in order to detect a user's hand in the present invention.
FIGS. 3 to 5 are views explaining that an existing elevator is equipped with the non-contact elevator touch device according to the present invention in an existing elevator.
FIG. 6 shows another embodiment of a non-contact elevator touch device according to the present invention.
FIG. 7 illustrates a data format used in a non-contact elevator touch device according to the present invention.
FIGS. 8 and 9 illustrate a process in which the button coordinates of the non-contact elevator touch device are matched with the button coordinates of the actual touch button during the process of installing the non-contact elevator touch device according to the present invention.

### DETAILED DESCRIPTION OF EXEMPLARY EMBODIMENT OF THE INVENTION

Hereinafter, a non-contact elevator touch device and a setting method thereof according to an embodiment of the present invention will be described in detail with reference to the accompanying drawings.

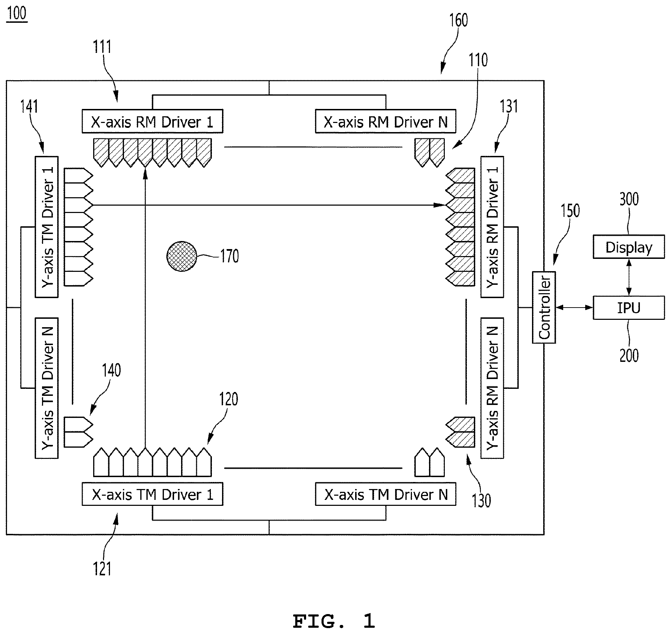

FIG. 1 illustrates a non-contact elevator touch device and a control method thereof according to the present invention.

Referring to FIG. 1, the non-contact elevator touch device according to the present invention includes a touch sensing unit 160, and a control unit 150 that controls the touch sensing unit 160 and provides touch coordinate information according to a signal from the touch sensing unit 160.

The control unit 150 provides the touch coordinate information to the information processing unit 200 provided in the elevator, and the information processing unit 200 displays the user's selected button through the display unit 300 provided in the elevator.

The touch sensing unit 160 detects a user's input action in a space apart from the surface of an elevator touch button rather than an elevator touch button (including a capacitive button), and the control unit 150 converts the information of the touch coordinates detected by the touch sensing unit 160 into the button coordinate information so to provide them.

The information processing unit 200 processes the information input from the control unit 150 or the information input when a user actually presses a touch button, to display the result on the display unit 300. Depending on the design, an information set module that provides the information processing unit 200 with at least one of the information input from the control unit 150 and the information input when the user actually presses the touch button may be further included.

The non-contact elevator touch device 100 includes a touch sensing unit 160 that includes X-axis receiving/transmitting modules 110 and 120, X-axis receiving/transmitting module drivers 111 and 121, Y-axis receiving/transmitting modules 130 and 140, and Y-axis receiving/transmitting module drivers 131 and 141. In addition, the non-contact elevator touch device 100 includes a controller 150 that controls the touch sensing unit 160 and senses touch coordinates by calculating touch coordinate information.

In the embodiment, directions such as the X axis or the Y axis are exemplified, but are not necessarily limited thereto, and even if the transmitting module and the receiving module are provided in various directions, it is possible to sense the touch position.

The non-contact elevator touch device 100 detects a change in the infrared signal by receiving the touch detection signal, for instance, a light signal (eg, an infrared signal) with the X-axis receiving module 110 and the Y-axis receiving module 130 and sensing them. The touch detection signal is output from the X-axis transmitting module 120 and the Y-axis transmitting module 140 under the control of the X-axis transmitting module driver 121 and the Y-axis transmitting module driver 141.

The controller 150 processes the infrared signals received from the X-axis receiving module 110 and the Y-axis receiving module 130 to calculate the coordinates of the location selected by the user. In addition, the controller 150 can calculate not only the touch coordinate information of the location selected by the user, but also the object size (eg, diameter) of the selected location. For example, when a user touches a specific point 170 on the sensing space with his/her finger, the controller 150 of the non-contact elevator touch device 100 calculates the part where the infrared signal is detected and the part where the infrared signal is not detected so as to sense the touch position (or object size of the position) of the user's finger on the X-Y plane. It is possible because the infrared signal is blocked by the user's finger.

Here, the user's touch does not mean that a finger actually touches the touch button of the elevator, but may mean that the user's finger is positioned in a space of a sensing area apart from the elevator touch button. Capacitive buttons require a user to actually touch the touch button or get his/her finger very close to it for touch recognition. The non-contact elevator touch device 100 according to the present invention, however, can detect a user's input operation, that is, a touch, even when a finger is located at a position away from an elevator touch button. That is, in the present invention, the user's input operation can be sensed even at a position away from the elevator touch button by such a distance that does not affect capacitance, rather than a distance that affects capacitance for a capacitive touch button.

That is, the non-contact elevator touch device 100 can detect a user's selected point located in the space between the X and Y axis transmitting modules 120 and 140 and the X and Y axis receiving modules 110 and 130.

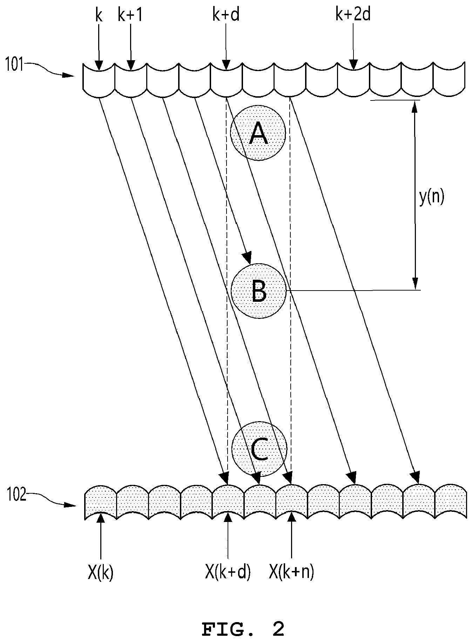

In addition, in the embodiment, the touch sensing unit 160 is exemplified as including the X-axis receiving/transmitting modules 110 and 120 and the Y-axis receiving/transmitting modules 130 and 140, but the receiving/transmitting module may be installed only on either the X axis or the Y axis. It will be described in FIG. 2.

FIG. 2 is a diagram for explaining one embodiment of a method of detecting an x-axis coordinate and a y-axis coordinate in order to detect a user's hand in the present invention.

Such technologies are described in detail in Korean Registered Patent No. 10-1076871, Korean Registered Patent No. 10-1372423, Korean Registered Patent No. 10-1057620, Korean Registered Patent No. 10-1260341, and Korean Registered Patent No. 10-1323196 filed by R&D Plus Co., Ltd., which are incorporated by reference into this patent application. Hereinafter, the coordinate detection technology will be briefly described.

Referring to FIG. 2, a touch measurement signal transmitting module 101 of FIG. 2 shows the X-axis transmitting modules 120 and the Y-axis transmitting modules 140 of FIG. 1 in detail, while a touch measurement signal receiving module 102 of FIG. 2 shows the X-axis receiving modules 110 and the Y-axis receiving modules 130 of FIG. 1 in detail. The touch measurement signal transmitting module 101 and the touch measurement signal receiving module 102 are disposed to face each other. In addition, it is possible that the touch measurement signal transmitting module 101 and the touch measurement signal receiving module 102 are disposed on both sides in order to minimize disturbance caused by an external infrared signal such as sunlight.

The touch measurement signal transmitting module 101 may be arranged as k, k+1, k+d, k+2d along the X-axis direction, and the touch measurement signal receiving module 102 may be arranged in the order of X(k), X(k+d), ..., X(k+n) along the X-axis direction.

Here, d means the position of the touch measurement signal receiving module 102 located at the oblique angle in which the infrared rays transmitted from the k-th touch measurement signal transmitting module 101 reach, and is a factor that determines the size of the oblique angle representing the slope of the infrared rays transmitted from the touch measurement signal transmitting module 101.

A, B, and C shown in FIG. 2 are examples of touch areas, and the user may choose one of A, B, and C and touch it, or perform multi-touch at the same time.

A touch object disposed in the touch area blocks a touch measurement signal. In other words, the touch object blocks the touch measurement signal which is output from the touch measurement signal transmitting module 101 and input to the touch measurement signal receiving module 102.

For example, when the specific touch measurement signal transmitting module 101 transmits a touch measurement signal, the touch measurement signal receiving module 102 that is disposed at various positions such as an acute angle, a right angle, and an obtuse angle with respect to the touch measurement signal transmitting module 101 sequentially scans it. And the touch measurement signal receiving module 102 receives the touch measurement signal while the touch measurement signal transmitting module 101 at various positions is being operated, thereby enabling a touch sensing unit 160 to detect the X-axis coordinate of the touch object.

The process of detecting the Y-axis coordinate, such as y(n), is the same as the process of detecting the X-axis coordinate. While the touch measurement signal transmitting module 101 and the touch measurement signal receiving module 102 operate sequentially, the Y-axis coordinate can be sensed by detecting a location where the touch measurement signal is blocked and not received.

In the case of multi-touch, false images may be generated, but in the present invention, false images are not generated.

The false images may be created because the touch measurement signal transmitting module 101 and the touch measurement signal receiving module 102 disposed on the X and Y axes scan in a matrix form. For example, in the case of scanning in a matrix form, when two different points of the touch area are touched, the four intersections of the lines drawn in the X-axis direction and the lines drawn in the Y-axis direction from each of the points may be interpreted as touch points. Two of them are not actual touch points which will be perceived as actual touch points but are actually false images.

However, in the present invention, the false images are not created because scanning is performed in various directions such as an acute angle, a right angle, and an obtuse angle, rather than a matrix scan.

Through the method exemplified as above, in the present invention, it is possible to sense the user's hand motion, and thereby, the user's desire can be understood.

In this way, the non-contact elevator touch device 100 may be configured in various forms to sense a user's input motion. For example, in FIG. 1, it is illustrated that the transmitting module and the receiving module are disposed facing each other, but it is also possible that the transmitting module and the receiving module are alternately arranged on both sides.

In addition, the non-contact elevator touch device 100 may use various scan methods and control methods so as to accurately sense a user's selection.

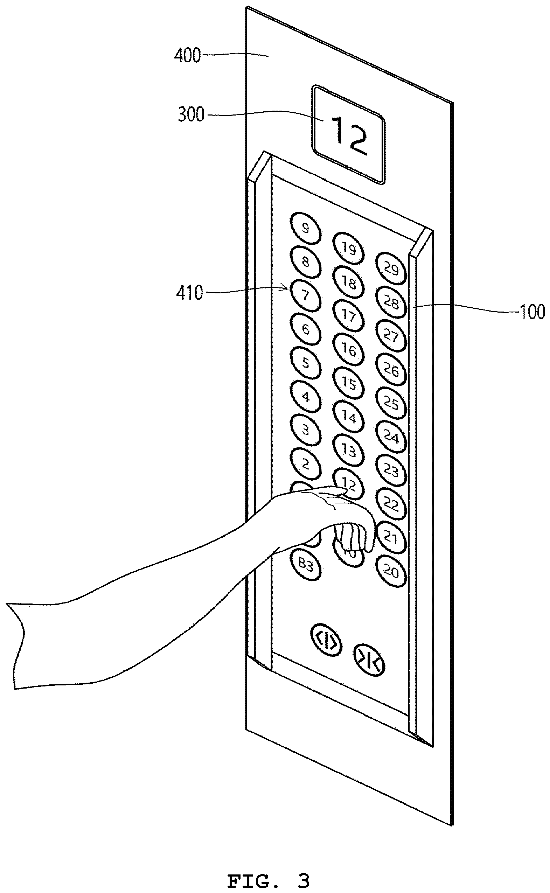

FIGS. 3 to 5 are views explaining that the non-contact elevator touch device according to the present invention is installed in an existing elevator.

Referring to FIG. 3, the conventional elevator control panel 400 is provided with a display unit 300 displaying the floor number on which the elevator is located, and a plurality of touch buttons 410. So, the non-contact elevator touch device 100 according to the present invention is installed around a plurality of the touch buttons 410.

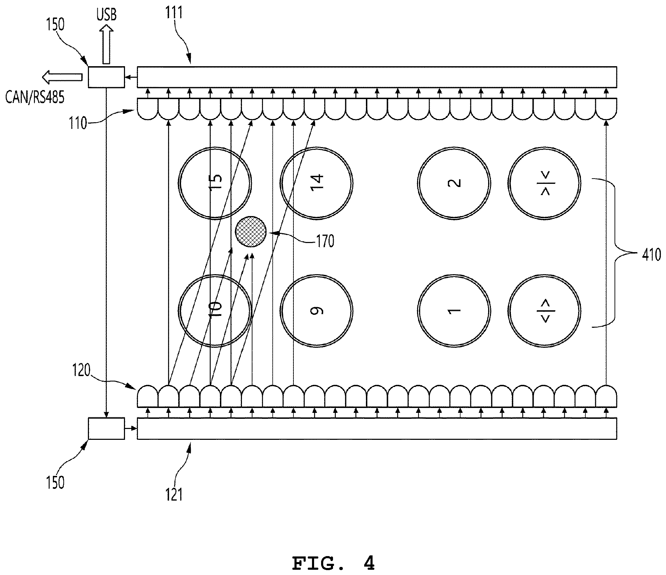

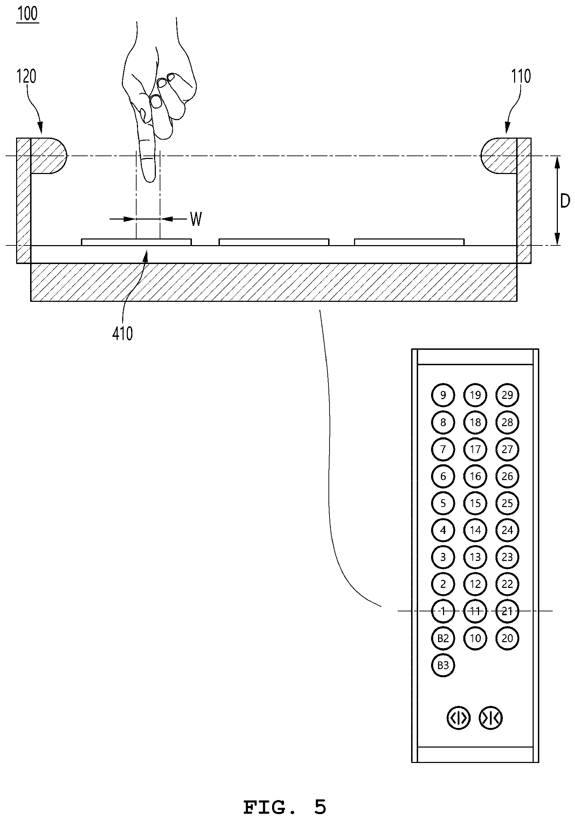

As shown in FIGS. 4 and 5, in the non-contact elevator touch device 100, the X-axis transmitting module 120 and the X-axis receiving module 110 are arranged to face each other so as to transmit and receive the light at the height spaced apart from the touch buttons 410 in a direction parallel to the touch buttons 410. For example, the X-axis transmitting module 120 and the X-axis receiving module 110 are disposed at a height (D), 1 to 10 cm apart from the plane of the elevator control panel 400 on which the touch buttons 410 are formed, so that an infrared signal may travel in a direction parallel to the elevator control panel 400.

The X-axis transmitting module 120 and the X-axis receiving module 110 are controlled by the X-axis transmitting module driver 121 and the X-axis receiving module driver 111, respectively. The X-axis transmitting module driver 121 and the X-axis receiving module driver 111 transmits and receives signals through the controller 150 to the information processing unit 200 previously installed in the elevator.

On the upper side of one of the touch buttons 410, coordinates are set in an area as large as the width (W) of the touch button 410. So, when the user's finger is located at a specific point 170, it is determined whether it is an upper position of the touch buttons 410 so to recognize whether the user inputs the non-contact elevator touch device 100.

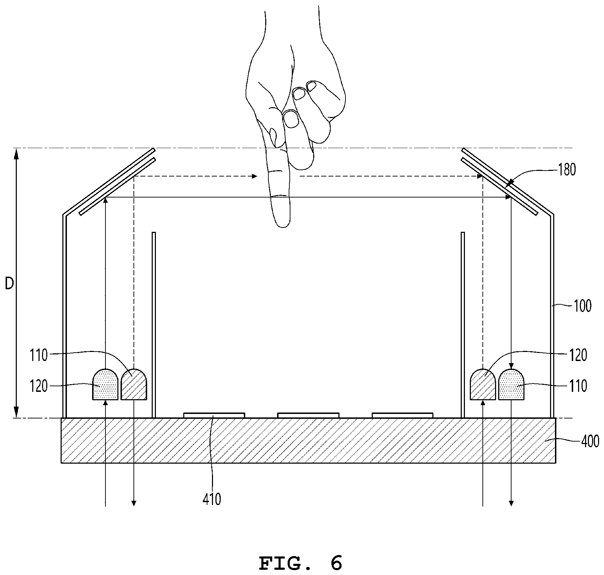

FIG. 6 shows another embodiment of a non-contact elevator touch device according to the present invention.

Referring to FIG. 6, FIGS. 3 to 5 exemplifies that the X-axis transmitting module 120 and the X-axis receiving module 110 are arranged to face each other so as to transmit and receive the light at the height spaced apart from the touch buttons 410 in a direction parallel to the touch buttons 410. FIG. 6 illustrates that the traveling direction of light is changed by a mirror 180.

The X-axis transmitting module 120 and the X-axis receiving module 110 are disposed in contact with or adjacent to the elevator control panel 400, so as to emit and receive the light in a direction perpendicular to the elevator control panel 400. The light emitted from the X-axis transmitting module 120 is reflected by the mirror 180 with a right angle and travels in a direction parallel to the elevator control panel 400.

In addition, the X-axis transmitting module 120 and the X-axis receiving module 110 are not disposed only on one side, but as shown in FIG. 6, the X-axis transmitting module 120 and the X-axis receiving module 110 may be disposed on both sides of the touch buttons 410, respectively.

In this way, since the non-contact elevator touch device 100 according to the present invention can be additionally installed on the existing elevator control panel 400 which has been already installed, there is an advantage in that it can be installed at low cost.

In addition, even if the user actually presses one of the touch buttons 410 even failing to recognize the existence of the non-contact elevator device 100, the elevator also operates normally and correctly.

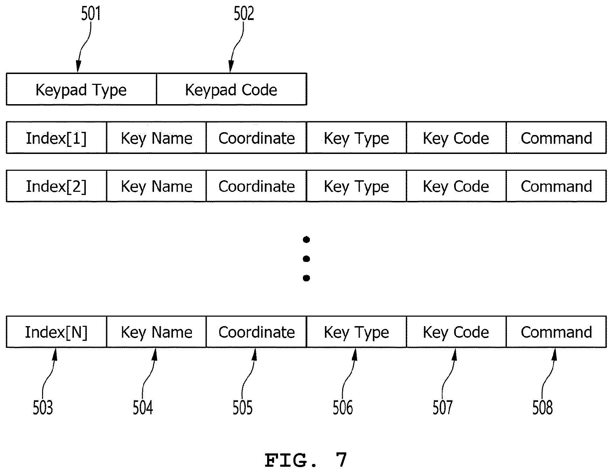

FIG. 7 illustrates a data format used in a non-contact elevator touch device according to the present invention.

Referring to FIG. 7, in order to make the conventionally installed elevator operated by the touch buttons 410 to be also operated by the non-contact elevator touch device 100 according to the present invention, it is necessary to match the touch coordinate information recognized by the non-contact elevator touch device 100 to the button coordinates of the actual touch buttons 410.

However, since there are many product models depending on the elevator manufacturer, a data format is prepared to efficiently match the coordinates.

In other words, there are a number of product models depending on the elevator manufacturer, and many button layouts of the various elevator control panel 400 according to each model should be considered.

Therefore, if a button layout database applicable to a plurality of elevator control panels 400 is available, it can be easier to install and operate the non-contact elevator touch device 100 of the present invention.

Depending on the manufacturer or model of the elevator, there may be a keypad type 501 having a plurality of button arrangements, and a keypad code 502 used as a search index during database search may be assigned according to the keypad type 501.

In addition, according to each keypad type 501, there may be an index 503, a key name 504, coordinates 505, a key type 506, a keycode 507, and a key command 508. The index 503 is a unique index of a keypad button. The key name 504 is a button name such as 1, 2, 3, open, or close. The coordinates 505 mean the effective coordinate space of the keypad buttons. The key type 506 is the shape of the keypad buttons. The key code 507 is a unique key number of the one keypad button. The key command 508 is a key command transmitted to the control module of the elevator.

Therefore, since the manufacturer or model name of the elevator control panel can be known when installing the non-contact elevator touch device 100 according to the present invention, it is possible to use the keypad database to set the non-contact elevator touch device 100 so as to quickly install it.

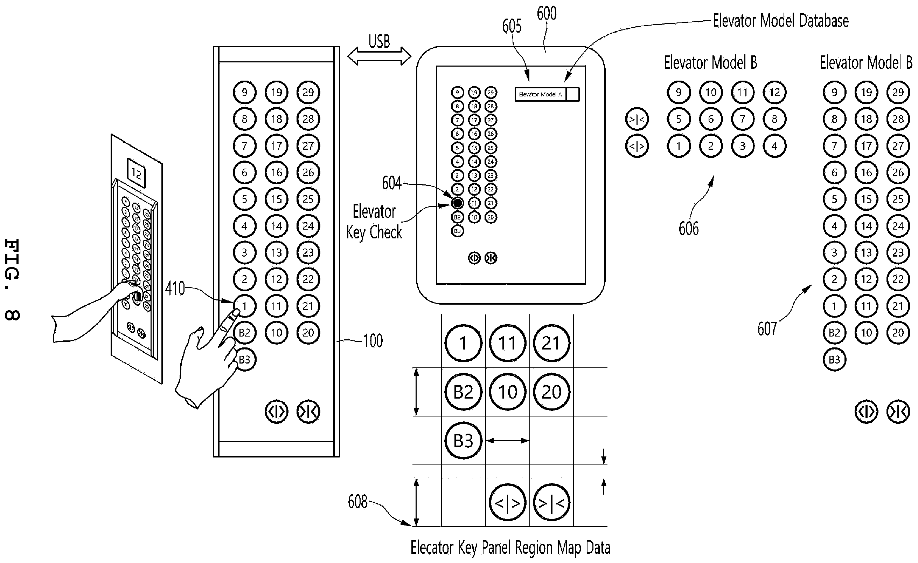

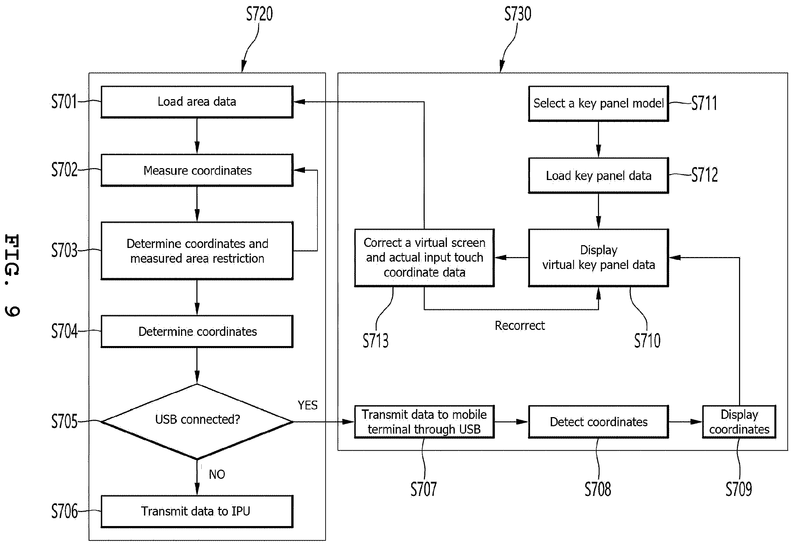

FIGS. 8 and 9 illustrate a process in which the button coordinates of the non-contact elevator touch device are matched with the button coordinates of the actual touch buttons 410 in the process of installing the non-contact elevator touch device according to the present invention.

Referring to FIGS. 8 and 9, the non-contact elevator touch device 100 according to the present invention is installed around the touch buttons 410 of an elevator that is conventionally installed and operated by the touch buttons 410, and is connected to the mobile terminal (600) through USB.

The mobile terminal 600 has keypad data that includes button arrangements for various elevator models. For example, suppose that it has keypad data 606 for elevator model A and keypad data 607 for elevator model B. Then, if the keypad data 607 for the elevator model B matches the installed elevator and so it is selected through the keypad model selection window 605, the button layout for the elevator model B is displayed on the screen of the mobile terminal 600. And then, the deployer checks whether the non-contact elevator touch device 100 can recognize touch coordinate information correctly and adjusts it through the mobile terminal 600 while he/she is trying to input floor numbers with his/her finger into the non-contact elevator touch device 100. On the screen of the mobile terminal 600, a portion where the deployer inputs with his/her finger may be displayed as a red circle 604.

In the non-contact elevator device 100, the touch coordinate areas 608 corresponding to the touch buttons 410 may be set as a rectangular shape as shown.

Through this adjustment process, the button coordinates of the non-contact elevator touch device 100 and the button position of the touch button 410 can be adjusted to match.

In FIG. 9, a block (S720) explains the operation process of the non-contact elevator touch device, and a block (S730) explains the process of connecting the mobile terminal to the non-contact elevator touch device and setting them.

Referring to FIG. 9, the controller 150 stores the data in the data format described in FIG. 7 in its own memory, and the controller 150 loads the data stored in its own memory. The loaded data may be the area data related to the sensing area (S701).

When an object such as a finger is located within the sensing area of the non-contact elevator touch device 100, touch coordinate and diameter of the object are measured (S702).

It is determined, by comparing with constraint variables, whether the measured touch coordinates are out of a specific area, whether the object diameter data is larger than a certain size, or whether the number of touch coordinates recognized as an object is larger than a preset value (S703).

If the touch coordinates are out of a specific area, and/or if the object diameter is larger than a predetermined size, and/or if the number of touch coordinates is large, the touch coordinates and the object diameter data value are specified again, otherwise the touch coordinates are determined (S704). In other words, the measured touch coordinates are compared with the button coordinate data described in FIG. 7, thereby to determine the area that includes the measured coordinates.

It determines whether the non-contact elevator touch device 100 is connected to the mobile terminal 600 via USB (S705), and if not connected, data is transmitted to the information processing unit 200 of the elevator (S706).

If the non-contact elevator touch device 100 is connected to the mobile terminal 600 via USB, it is recognized as a process of setting the non-contact elevator touch device 100 and the touch coordinate information is transmitted to the mobile terminal 600 through USB (S707).

The mobile terminal 600 detects the touch coordinates (S708) and displays the transmitted touch coordinates on the screen (S709). And, as described above, it may be displayed as a red circle 604.

At this time, the deployer selects a key panel model with the mobile terminal 600 (S711), and the mobile terminal 600 loads key panel data (S712) and displays virtual key panel data (S710). So, the button arrangement of a virtual screen and the actual input touch coordinate data can be corrected (S713).

The touch coordinate data corrected in this way can be stored in the memory of the controller 150 through USB, and so it is possible to detect the button selected by the user using the corrected touch coordinates.

In the non-contact elevator touch device according to the present invention, it is possible for passengers to move to a desired floor without pressing the touch button with their own finger.

In addition, the method of setting the non-contact elevator touch device according to the present invention can quickly and accurately match the non-contact elevator touch device and the positions of the touch buttons of the elevator by using key panel data of a plurality of elevator models.

Although the above has been described with reference to the embodiments, these are merely examples and do not limit the present invention, and it will be appreciated that various variations and applications are possible for those skilled in the art to which the present invention belongs without deviating from the essential characteristics of the present embodiment. For example, each component specifically shown in the embodiment can be modified and implemented. And the differences related to these modifications and applications should be construed as being included in the scope of the present invention as defined in the appended claims.

### INDUSTRIAL APPLICABILITY

The present invention can provide an elevator touch device.

## Claims

1. A non-contact elevator touch device comprising:
a touch sensing unit installed around touch buttons of an elevator control panel and for sensing a touch according to an infrared signal traveling in a direction parallel to the elevator control panel at a position 1 to 10 cm apart from the elevator control panel in a perpendicular direction; and
a controller providing touch coordinate information according to the signal of the touch sensing unit.

2. The non-contact elevator touch device of claim 1, further comprising:
an information set module for providing at least one of information input from the touch buttons and information input from the controller to an information processing unit of the elevator.

3. The non-contact elevator touch device of claim 1, wherein the touch sensing unit includes an infrared emitting module and an infrared receiving module,
wherein the infrared emitting module and the infrared receiving module emit and receive light in a direction perpendicular to the elevator control panel,
wherein the touch sensing unit further includes a mirror that allows the light emitted from the infrared emitting module to travel in a direction parallel to the elevator control panel.

4. The non-contact elevator touch device of claim 1, wherein the controller converts the touch coordinate information into button coordinate information and provides it.

5. A method for setting a non-contact elevator touch device comprising: a touch sensing unit installed around touch buttons of an elevator control panel and for sensing a touch according to an infrared signal traveling in a direction parallel to the elevator control panel at a position 1 to 10 cm apart from the elevator control panel in a perpendicular direction; and a controller providing touch coordinate information according to the signal of the touch sensing unit, the method including the steps of:
(a) installing a non-contact elevator touch device around the touch buttons of the elevator control panel;
(b) connecting a mobile terminal storing key panel data of elevator models to the non-contact elevator touch device;
(c) displaying key panel data displayed on the mobile terminal and information of touch coordinates sensed by the non-contact elevator touch device at the same time on the mobile terminal; and
(d) adjusting and setting the key panel data and the information of the touch coordinates sensed by the non-contact elevator touch device.
